# EUROPEAN PATENT SPECIFICATION

(11) **EP 0 949 855 B1**
(45) Date of publication and mention of the grant of the patent: **31.05.2006**
(21) Application number: 99302743.2
(22) Date of filing: 08.04.1999
(51) Int. Cl.: H05K 3/46

(54) **Process for producing a multilayer circuit board having an electroplated blind hole**
Verfahren zur Herstellung einer mit elektroplattiertem Sackloch versehenen mehrschichtige Leiterplatte
Procédé pour fabriquer une plaque à circuit multicouche pourvue d'un trou borgne métallisé par électrodéposition

(30) Priority: 04.11.1998 JP 31295898; 10.04.1998 JP 9906798
(43) Date of publication of application: 13.10.1999
(73) Proprietor: SHINKO ELECTRIC INDUSTRIES CO. LTD., Nagano-shi, Nagano 380-0921 (JP)
(72) Inventor: Rokugawa, Akio, c/o Shinko Elec. Ind. Co., Ltd., Nagano-shi, Nagano 380-0921 (JP); Iijima, Takahiro, c/o Shinko Elec. Ind. Co., Ltd., Nagano-shi, Nagano 380-0921 (JP); Nomura, Tomohiro, c/o Shinko Elec. Ind. Co., Ltd., Nagano-shi, Nagano 380-0921 (JP); Koyama, Toshinori, c/o Shinko Elec. Ind. Co., Ltd., Nagano-shi, Nagano 380-0921 (JP); Katagiri, Noritaka, c/o Shinko Elec. Ind.Co., Ltd., Nagano-shi, Nagano 380-0921 (JP)
(74) Representative: Finnie, Peter John

(56) References cited:
- EP-A- 0 164 564
- US-A- 3 350 498
- US-A- 4 642 160
- PATENT ABSTRACTS OF JAPAN vol. 98, no. 4, 31 March 1998 (1998-03-31) & JP 09 331155 A (ELNA CO), 22 December 1997 (1997-12-22)
- PATENT ABSTRACTS OF JAPAN vol. 15, no. 419 (E-1126), 24 October 1991 (1991-10-24) & JP 03 173497 A (HITACHI CABLE), 26 July 1991 (1991-07-26)
- PATENT ABSTRACTS OF JAPAN vol. 98, no. 5, 30 April 1998 (1998-04-30) & JP 10 027960 A (MITSUI MINING & SMELTING CO), 27 January 1998 (1998-01-27)

## Description

The present invention relates to a process for producing a multilayer circuit board and, more particularly, to a process for producing a multilayer circuit board having a blind via hole which is filled with plated film.

Various processes for making a multilayer circuit board are conventionally known.

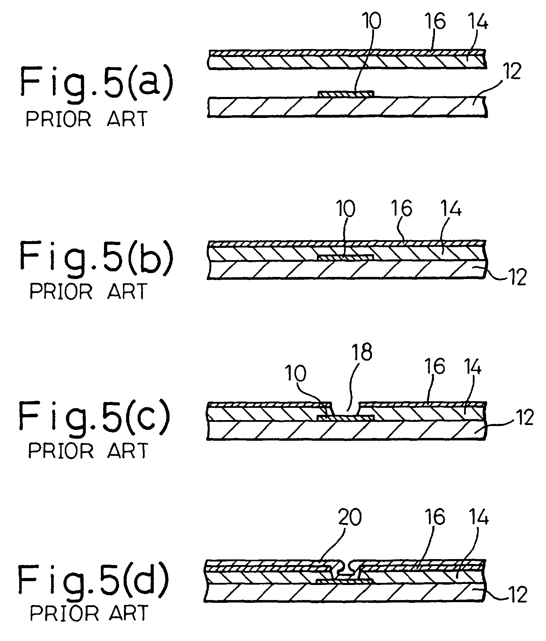

Figs. 5(a) to 5(c) shows one of the known processes for producing a multilayer circuit board.

First, on a resin base 12 on which a wiring pattern is formed, a metal foil, such as a copper foil or the like, with an adhesive resin layer, such as a pre-preg or polyimide resin layer, is laminated and heat-pressed so that the metal foil 16 is adhered onto the resin base 12, as shown in Figs. 5(a) and 5(b).

Then, using a metal plate as a masking, a blind via hole 18 is formed by a carbon dioxide gas laser through the metal foil 16 and the resin layer 14 so that a part of the wiring pattern 10 is exposed, as shown in Fig. 5(c).

Then, an electroless-copper plating or electro-copper plating is applied to the blind via hole 18 to form a plated film 20 to attain an electrical connection between the wiring pattern 10 and the metal foil 16, as shown in Fig. 5(d).

Then, the metal foil 16 is etched to form a predetermined wiring pattern (not shown).

The above-mentioned processes are repeated for several times and, thereby, a multilayer circuit board can be obtained.

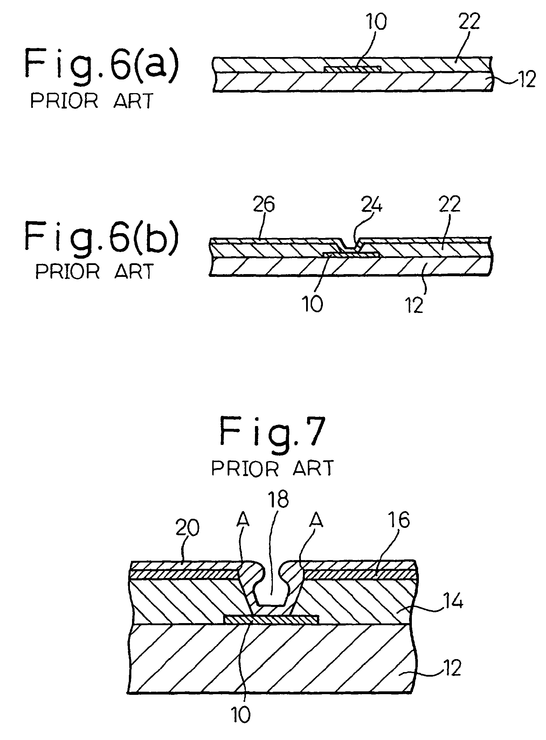

Figs. 6(a) and 6(b) show another known process for producing a multilayer circuit board.

In this process, on the resin base 12 on which a wiring pattern is formed, a photosensitive resin layer 22 is formed, as shown in Fig. 6(a).

Then, the photosensitive resin layer 22 is etched by a photolithographic method to form a blind via hole 24 which reaches to the circuit pattern 10, a plated film 26 is formed on the blind via hole 24 and the resin layer 22 by a sputtering process and an electro-plating process, as shown in Fig. 6 (b), and the plated film formed on the resin layer 22 is etched to form a desired circuit pattern.

As mentioned above, there are various known processes for producing a multilayer circuit board. In the known method shown in Figs. 6(a) and 6(b), an electro-plated film is formed on the resin layer 22 through the sputtered film but the adhesivity between the resin layer 22 and the sputtered film is not strong. Thus, a problem of peeling-off will occur.

In the process shown in Figs. 5(a) to 5(d), since the metal foil 16 is beforehand adhered to the resin layer 14 with a predetermined strength, a multilayer circuit board having a good adhesivity with the resin material can thus be provided.

However, the following problems will arise even in the process shown in Figs. 5(a) to 5(d).

Recently, there is a great demand that the circuit pattern should be very dense and sophisticated. Therefore, the width of line becomes very narrow and thus it is required that the diameter of the above-mentioned blind via 18 for connecting upper and lower circuit patterns therebetween must be made very small.

In addition, the blind via hole 18 is generally formed by a carbon dioxide laser as mentioned above. In this case, however, such a carbon dioxide laser is limited to form a hole, the diameter thereof being 80 µm or more. Consequently, it is impossible to form such a via hole, the diameter thereof being less than 80 µm, using a carbon dioxide laser.

In a process during which the diameter of the blind via hole 18 becomes very small, if the plated film 20 is formed by an electro-plating process, as shown in Fig. 7, the electric current may be concentrated at the angle portion A of the metal foil 16, i.e., an inlet edge of the blind via hole 18. As a result of the electric current being concentrated at the angle portion A, the inlet edge of the blind via hole 18 may become "necked", the diameter of the inlet portion being narrow, and the plating liquid may enter therein and affectedly influence the plated film. On the contrary, the diameter deep inside the blind via hole 18 becomes relatively large and the thickness of the plated layer becomes thin. Thus, an electrical disconnection may occur in the blind via hole.

Releiant prior art includes documents JP 09 331155 A and JP 03 173497 A

An object of the present invention is to provide a process for producing a multilayer circuit board in which a blind via hole of a small diameter can be made and high density wiring can be provided.

Another object of the present invention is to provide a process for producing a multilayer circuit board in which the above-mentioned drawbacks can be overcome.

According to the present invention, there is provided a process for producing a multilayer wiring board comprising the steps of: laminating an electrically insulating resin substrate, having first and second surfaces and a metal layer formed on the first surface, onto a base material on which a predetermined wiring pattern is formed, so that the second surface of the resin substrate is adhered to said base material; removing a predetermined amount of said metal layer to form an opening having a first diameter at a position where a connection with said wiring pattern is to be attained; irradiating a laser beam toward said resin layer through said resin removed region to form a blind via hole having a diameter smaller than that of said opening, so that said wiring pattern is exposed at a bottom of said blind via hole and a step portion of the resin substrate remains adjacent a periphery of said blind via hole; electroless plating to form an electroless plated film on said exposed wiring pattern, a side wall of said blind via hole, the step portion of said exposed resin layer, and at least a portion of the metal layer adjacent a periphery of said opening; electro plating at a density of electric current of 0.1 to 2 ASD (A/dm²) to form an electro plated film on said electro-less plated film, so that a plating deposition speed on a face of the electroless plated film in said blind via hole is higher than that on a substantially flat surface of the electroless plated film on said metal layer formed on the resin layer; and after said electro plating, etching said metal layer to form a predetermined wiring pattern.

The laser beam irradiating step comprises a step of irradiating a laser beam having a wavelength in the ultraviolet range.

### BRIEF DESCRIPTION OF THE DRAWINGS

Figs. 1(a) to 1(f) are cross-sectional views illustrating an embodiment of a process for producing a multilayer wiring board according to the present invention;
Figs. 2(a) and 2(b) are cross-sectional views illustrating another embodiment according to the present invention;
Fig. 3 is a cross-sectional view for explaining a blind via hole filled with a plated film;
Figs. 4(a) to 4(i) are cross-sectional views illustrating a comparative embodiment.
Figs. 5(a) to 5(d) are cross-sectional views illustrating a process for producing a multilayer wiring board known in the prior art;
Figs. 6(a) and 6(b) are cross-sectional views illustrating another known process for producing a multilayer wiring board; and
Fig. 7 is a cross-sectional view for explaining an example in which the blind via hole is filled with a plated film in a "necked" manner.

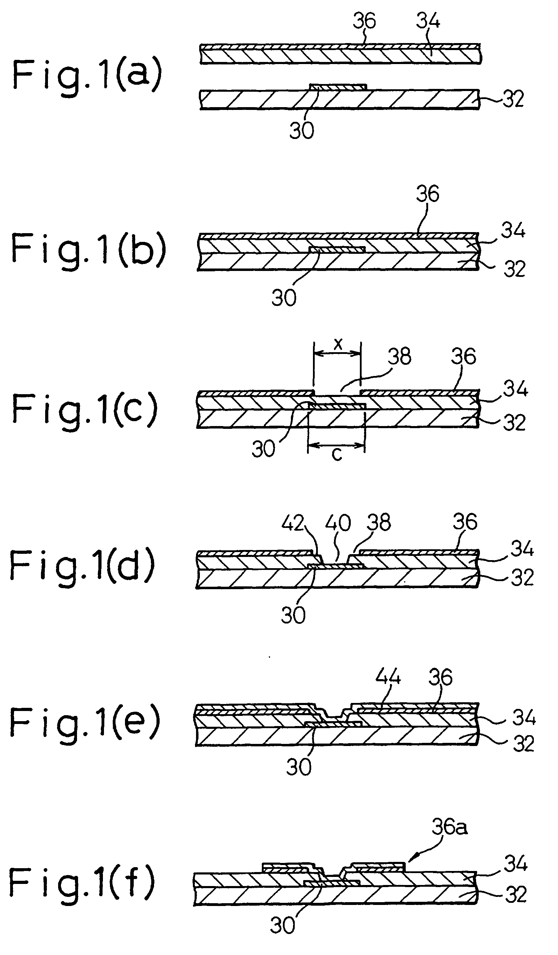

In the drawings, Figs. 1(a) to 1(f) show a first embodiment of this invention.

A circuit pattern 30 is formed on the base substrate 32 (a printed circuit board, a ceramic circuit board, or the like). A resin substrate with metal foil, which comprises an adhesive resin layer 34, such as a pre-preg, a polyimide resin layer or the like, formed on one surface of a metal foil 36, such as a copper foil, is laminated on the circuit pattern 30, as shown in Fig. 1(a).

The resin layer 34 is then pressed and heated to harden the same so that the substrate 32 is adhered to the metal foil 36 through the resin layer 34.

Then, the metal foil 36 at the portion of the lands corresponding to the connecting portion of the blind via connecting portion is removed by an etching process or a laser process to form an opening 38 so that a part of resin layer 34 is exposed, as shown in Fig. 1(c).

It is preferable that the diameter X of the opening 38 is smaller than the width C of the land of the wiring pattern 30. As mentioned hereafter, the position of the opening 38 is made as connecting portion between the upper and lower wiring patterns. Since the diameter of this connecting portion is smaller than the diameter C of the land, the wiring density thereof is not affected and high density wiring can thus be attained.

A resin substrate with metal foil, in which an opening is beforehand provided at a position of the metal foil corresponding to the lands of the wiring pattern, can also be laminated with each other.

A blind via hole 40 is formed at a position of the resin layer 34 at which the resin layer 34 is exposed and the exposed portion becomes the bottom of the blind via hole 30, as shown in Fig. 1(d). The diameter of the blind via hole 40 is smaller than that of the opening 38.

The blind via hole 40 can be formed by a laser process. As mentioned hereinbefore, a carbon dioxide laser is not suitable since it is difficult to bore a hole having a diameter of less than 80 µm by a carbon dioxide laser. Although a mask, i.e., a metal mask, can be used to form such a hole having a small diameter, the productivity of such method is relatively now.

Therefore, it is suitable to use a YAG laser or IRF laser, without using any masking, to bore a hole which has a diameter of more or less 30 µm, in which the wavelength is in the ultraviolet range so as to reduce the diameter thereof.

Otherwise, it is also suitable to bore a hole having a small diameter by an excimer laser, the wavelength thereof being in the ultraviolet range.

The carbon chain of the resin layer 34 can be cut so that the resin layer 34 is resolved and removed by irradiating a laser beam having wavelength in the ultraviolet range.

The laser beam can be reduced to a small beam diameter and the diameter of the opening 38 can be made larger within the range of the land of the wiring pattern. The alignment, when the laser beam is irradiated, can easily be performed. Since the diameter of the blind via hole 40 is smaller than the diameter of the opening 38, a step portion 42 of the resin layer 34 can thus remain around the periphery of the opening of the blind via hole 40.

After any processing wastes due to the laser beam processing are removed, an electroless plated layer, such as a copper layer, is formed on the surface of the wiring pattern 30, the side wall of the blind via hole 40, the exposed step portion 42 of the resin layer 34 and at least the surface of the metal foil 36, such as copper foil around the opening 38. Then, an electro plated layer 44 is formed on this electroless plated layer, as shown in Fig. 1 (e).

Then, as shown in Fig. 1(f), a predetermined wiring pattern 36a is formed by etching the metal foil 36, and the layer 44

The above-mentioned processes are repeated and, thus, a multilayer wiring pattern 36a is formed.

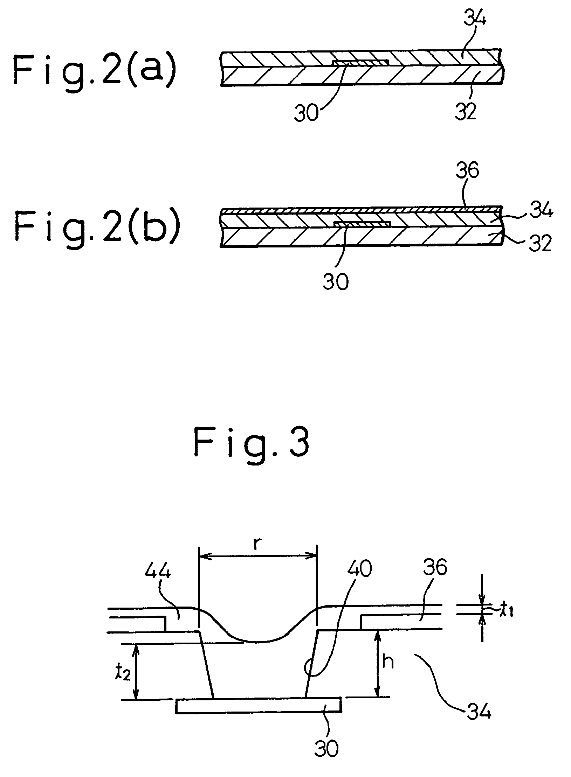

As mentioned above, according to the embodiment of this invention, the diameter of the opening 38 is larger than the diameter of the blind via hole 40 and, therefore, the step portion 42 remains on the resin layer 34. The edge of the opening 38 of the metal foil 36 is removed from the opening edge of the via hole 40 and, therefore, when an electroplated film 44 is formed, even if the electric current is concentrated to the corner portion of the metal foil 36 at the edge of the opening 38 and, thus, the thickness of the plated film at the corner portion becomes larger, the recess comprising the opening 38 and the blind via hole 40 does not become a "neck", different from the prior art shown in Fig. 3. Since the inlet portion is wide open, the plating liquid does not remain in the recess and the flow of the plating liquid can be maintained. Therefore, the plated film can be formed smoothly even at the bottom portion of the via hole 40.

Figs. 2(a) and 2(b) show a second embodiment of this invention. In this embodiment, as shown in Fig. 2(a), a base material 32, such as a printed circuit board on which a circuit pattern 30 is formed, is coated with a resin such as a polyimide resin, and is heated to form a resin layer 34. This resin layer 34 can also be formed on the base material by laminating a resin film.

Then, as shown in Fig. 2(b), a metal foil 36 is adhered onto the resin layer 34 by means of an adhesive.

The subsequent processes are the same as the steps as described and shown in Figs. 1(c) to 1(f) and therefore a detailed explanation thereof is omitted. In this second embodiment, the same effects and advantages as the first embodiment can be obtained.

According to the present invention, after the blind via hole 40 is formed as shown in Fig. 1 (d), an electroless copper plating is conducted and then an electro copper plated film 44 is formed as shown in Fig. 1(e). At this time, by the results of an experiment, it was confirmed that the blind via hole 40 could be substantially filled with the electro-copper plated film 44, as shown in Fig. 3. That is to say, the density of electric current when conducting the electro copper plating could be reduced to less than an ordinary density of electric current (2 to 3 ASD).

Usually, the inside area of the blind via hole 40 restricts the flow of the plating material more than a flat surface, such as a surface of the conductive layer 36 formed on the resin layer 34. However, it was observed that since the density of electric current could be reduced to 0.1 to 2 ASD, preferably to around 1 ASD, the difference in the plating deposition speed between the flat surface and the inside of the blind via hole 40 was uniform, or otherwise the plating deposition speed at the blind via hole 40 was higher than that on the flat surface.

If the plating deposition speed at the blind via hole 40 becomes higher, the plating film can heap up not only at the bottom surface of the blind via hole 40, but also at the side surface thereof. Therefore, the thickness t₂ of the plated film from the bottom becomes larger than the thickness t₁ of the plated film at the flat surface and therefore it is possible to completely cover the blind via hole 40.

If the plating deposition time was increased to form a thick plated film, the blind via hole 40 could finally be filled completely with the plated film. However, as the result of a reduction in the density of electric current as mentioned above, 1 when the diameter (r) of the opening of the blind via hole 40 was 50 µm and the depth (h) thereof was 40 µm, in which the thickness of the metal foil 36 (the thickness thereof being 5 µm) and the thickness t₁ of the plated film (the sum of the thickness of the electroless plated film and the thickness of the electro plated film) was 20 µm, the inside of the blind via hole 40 could substantially be filled with the plated film.

In order to fill the inside of the blind via hole 40 with the plated film, the most important factor is to reduce the density of electric current in the process of electro plating.

The other factors will be considered as follows.

First of all, the following conditions of the electroless plating are the most preferable.
the deposition speed: 0.2 to 3 µm/hr, and
the thickness of the plated film: 0.5 to 3.0 µm.

Also, it is preferable that the blind via hole 40 is tapered in such a manner that the inlet portion thereof is enlarged, since the plating liquid can circulate easily and deposition efficiency is improved.

In addition, assuming that the diameter of the opening of the blind via hole 40 was r, the depth thereof was h, the aspect ratio h/r was preferably 0.5 to 1.5.

Under the above-mentioned conditions:
t₂ > t₁, and
t₂ > h/2,
a plated film having a thickness t₂ of the plated film can be obtained, in which t₂ satisfies the above conditions.

The diameter r of the opening of the blind via hole 40 is preferably 20 to 100 µm and the depth h thereof is preferably 20 to 100 µm. The aspect ratio h/r is preferably 0.5 to 1.5 as mentioned above.

In order to fill the inside of the blind via hole 40 with the plated film, it is not always necessary to remove the metal foil 36, existing around the blind via hole 40, from around the opening, as illustrated. Even if there is no metal foil 36, it will be possible to fill the blind via hole 40 with the plated film.

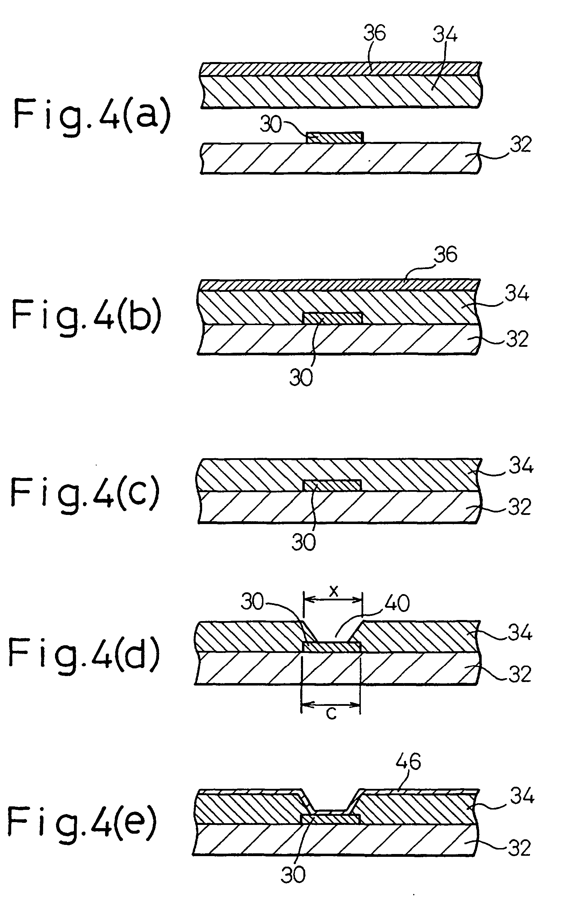

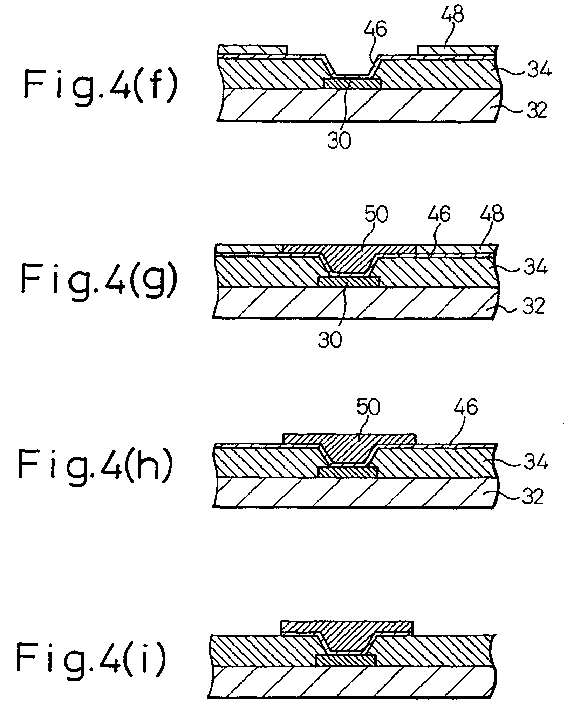

Figs. 4(a) to 4(i) show a process for producing a multilayer wiring board of a comparative embodiment.

Figs. 4(a) and 4(b) corresponds to Fig. 1(a) and 1(b), respectively, and therefore a detailed explanation is omitted. In Fig. 4(c), the copper foil 36 is completely removed from the upper surface of the adhesive resin layer 34. Then, a blind via hole 40 is formed by a laser process at a position of the resin layer 34 by which the circuit pattern 30 is exposed and the exposed portion becomes a bottom of the blind via hole 40, as shown in Fig. 4(d).

Then, an electroless plated layer 46, such as a copper layer, is formed on the surface of the wiring pattern 30, on the side wall of the blind via hole 40, and on the surface of the resin layer 34 around the blind via hole 40, as shown in Fig. 4(e). Then, a resist 48 is formed on the resin layer 34 except for the area of the blind via hole 40 and the peripheral region thereof, as shown in Fig. 4(f). Then, an electro plated layer 50 is formed on this electroless plated layer, except for the area covered by the resist 48, as shown in Fig. 4(g). Then, the resist 48 is removed by a known process, as shown in Fig. 4(h) and also the electroless plated layer 46 is removed by etching, as shown in Fig. 4(i).

## Claims

1. A process for producing a multilayer wiring board comprising the steps of:
laminating an electrically insulating resin substrate (34), having first and second surfaces and a metal layer (36) formed on the first surface, onto a base material (32) on which a predetermined wiring pattern (30) is formed, so that the second surface of the resin substrate (34) is adhered to said base material (32);
removing a predetermined amount of said metal layer (36) to form an opening (38) having a first diameter at a position where a connection with said wiring pattern is to be attained;
irradiating a laser beam toward said resin layer through said resin removed region to form a blind via hole (40) having a diameter smaller than that of said opening (38), until said wiring pattern (30) is exposed at the bottom of said blind via hole (40) and a step portion (42) of the resin substrate (34) remains adjacent a periphery of said blind via hole (40);
electroless plating to form an electroless copper plated film on said exposed wiring pattern (30), on the side wall of said blind via hole (40), on the step portion (42) of said exposed resin layer (34), and on at least a portion of the metal layer adjacent a periphery of said opening (38);
electro plating at a density of electric current of 0.1 to 2 ASD (A/dm²) to form an electroplated copper film on said electroless copper plated film, so that the plating speed on the surface of the electroless copper plated film in said blind via hole (40) is higher than that on the flat surface of the electroless copper plated film on said metal layer formed on the resin layer (34); and
after said electro plating, etching said metal layer (36) to form a predetermined wiring pattern (36a).

2. A process as set forth in claim 1, wherein the diameter of said opening (38) of the metal layer (36) is smaller than the width of the wiring pattern (30).

3. A process as set forth in claim 1 or 2, wherein said laser beam irradiating step comprises a step of irradiating a laser beam having a wavelength in the ultraviolet range.

4. A process according to any one of claims 1 to 3, wherein the periphery of the blind via hole (40) has a diameter of between 70 to 100 µm.

## Patentansprüche

1. Verfahren zur Herstellung einer mehrschichtigen Leiterplatte, umfassend folgende Schritte:
Laminieren eines elektrisch isolierenden Harzsubstrats (34), das eine erste und eine zweite Oberfläche aufweist und auf der ersten Oberfläche mit einer Metallschicht (36) versehen ist, auf ein Basismaterial (32), auf dem ein vorab festgelegtes Verdrahtungsmuster (30) gebildet ist, so dass die zweite Oberfläche des Harzsubstrats (34) auf das Basismaterial (32) geklebt wird;
Entfernen einer vorab festgelegten Menge der Metallschicht (36), um eine Öffnung (38) zu bilden, die einen ersten Durchmesser an einer Stelle aufweist, an der eine Verbindung mit dem Verdrahtungsmuster erzielt werden soll;
Richten eines Laserstrahls auf die Harzschicht durch den vom Harz befreiten Bereich, um eine blinde Durchkontaktierung (40) zu bilden, deren Durchmesser kleiner ist als derjenige der Öffnung (38), bis das Verdrahtungsmuster (30) am Boden der blinden Durchkontaktierung (40) freigelegt ist und eine Stufe (42) des Harzsubstrats (34) angrenzend an eine Peripherie der blinden Durchkontaktierung (40) verbleibt;
Chemische Metallisierung, um eine chemisch mit Kupfer beschichtete Schicht auf dem freigelegten Verdrahtungsmuster 30, auf der Seitenwand der blinden Durchkontaktierung (40), auf der Stufe (42) der freigelegten Harzschicht (34) und auf wenigstens einem Teil der Metallschicht angrenzend an eine Peripherie der Öffnung (38) zu bilden;
galvanische Metallisierung bei einer Stromdichte von 0,1 bis 2 ASD (A/dm²), um eine galvanisch mit Kupfer beschichtete Schicht auf die chemisch mit Kupfer beschichtete Schicht aufzubringen, so dass die Metallisierungsgeschwindigkeit auf der Oberfläche der chemisch mit Kupfer beschichteten Schicht in der blinden Durchkontaktierung (40) höher ist als die auf der ebenen Oberfläche der chemisch mit Kupfer beschichteten Schicht auf der auf der Harzschicht (34) gebildeten Metallschicht; und,
nach erfolgter galvanischer Metallisierung, Ätzen der Metallschicht (36), um ein vorab festgelegtes Verdrahtungsmuster (36a) zu bilden.

2. Verfahren nach Anspruch 1, wobei der Durchmesser der Öffnung (38) der Metallschicht (36) kleiner ist als die Breite des Verdrahtungsmusters (30).

3. Verfahren nach Anspruch 1 oder 2, wobei der Schritt des Richtens eines Laserstrahls einen Schritt umfasst, bei dem für die Bestrahlung ein Laserstrahl mit einer Wellenlänge im ultravioletten Bereich verwendet wird.

4. Verfahren nach einem der Ansprüche 1 bis 3, wobei die Peripherie der blinden Durchkontaktierung (40) einen Durchmesser zwischen 70 bis 100µm aufweist.

## Revendications

1. Procédé pour la production d'une plaquette de câblage multicouche comprenant les étapes qui consistent :
à stratifier un substrat (34) en résine électriquement isolante, ayant des première et seconde surfaces et une couche métallique (36) formée sur la première surface, sur une matière de base (32) sur laquelle un motif de câblage prédéterminé (30) est formé, afin que la seconde surface du substrat (34) en résine adhère à ladite matière de base (32) ;
à enlever une quantité prédéterminée de ladite couche métallique (36) pour former une ouverture (38) ayant un premier diamètre dans une position où une connexion avec ledit motif de câblage doit être réalisée ;
à irradier d'un faisceau laser ladite couche de résine à travers ladite région enlevée de résine pour former un trou borgne (40) de communication ayant un diamètre inférieur à celui de ladite ouverture (38), jusqu'à ce que ledit motif de câblage (30) soit à découvert au fond dudit trou borgne (40) de communication et qu'une partie épaulée (42) du substrat en résine (34) reste à proximité immédiate d'une périphérie dudit trou borgne (40) de communication ;
à effectuer un dépôt sans courant pour former un film de cuivre déposé sans courant sur ledit motif de câblage à découvert (30), sur la paroi latérale dudit trou borgne (40) de communication, sur la partie épaulée (42) de ladite couche de résine à découvert (34), et sur au moins une partie de la couche métallique adjacente à une périphérie de ladite ouverture (38) ;
à effectuer une électrodéposition à une densité de courant électrique de 0,1 à 2 ASD (A/dm²) pour former un film de cuivre électrodéposé sur ledit film de cuivre déposé sans courant, de manière que la vitesse de dépôt sur la surface du film de cuivre déposé sans courant dans ledit trou borgne (40) de communication soit supérieure à ce qu'elle est sur la surface plate du film de cuivre déposé sans courant sur ladite couche métallique formée sur la couche de résine (34) ; et
après ladite électrodéposition, à attaquer ladite couche métallique (36) pour former un motif de câblage prédéterminé (36a).

2. Procédé selon la revendication 1, dans lequel le diamètre de ladite ouverture (38) de la couche métallique (36) est inférieur à la largeur du motif de câblage (30).

3. Procédé selon la revendication 1 ou 2, dans lequel ladite étape d'irradiation par un faisceau laser comprend une étape d'irradiation par un faisceau laser ayant une longueur d'onde dans la bande ultraviolette.

4. Procédé selon l'une quelconque des revendications 1 à 3, dans lequel la périphérie du trou borgne de communication (40) a un diamètre compris entre 70 et 100 µm.
